# EUROPEAN PATENT SPECIFICATION

(11) **EP 1 749 900 B1**
(45) Date of publication and mention of the grant of the patent: **03.09.2014**
(21) Application number: 05741152.2
(22) Date of filing: 17.05.2005
(51) Int. Cl.: H01L 21/687, C23C 16/458, H01L 21/205, H01L 21/68, C30B 25/12

(54) **SUSCEPTOR FOR VAPOR DEPOSITION APPARATUS**
SUSZEPTOR FÜR DAMPFABSCHEIDUNGSVORRICHTUNG
COMPENSATEUR POUR APPAREIL DE DEPOSITION DE PHASE VAPEUR

(30) Priority: 18.05.2004 JP 2004147638
(43) Date of publication of application: 07.02.2007
(73) Proprietor: SUMCO Corporation, Tokyo 105-8634 (JP)
(72) Inventor: FUJIKAWA, Takashi, SUMITOMO MITSUBISHI SILICON CO, Tokyo 1058634 (JP); ISHIBASHI,Masayuki, SUMITOMO MITSUBISHI SILICON CO, Tokyo 1058634 (JP); DOHI, Takayuki, SUMITOMO MITSUBISHI SILICON CO, Tokyo 1058634 (JP); SUGIMOTO, Seiji, SUMITOMO MITSUBISHI SILICON CO, Tokyo 1058634 (JP)
(74) Representative: Banzer, Hans-Jörg
(86) International application number: PCT/JP2005/008979
(87) International publication number: WO 2005/111266

(56) References cited:
- WO-A1-03/060967
- JP-A- 2001 127 142
- JP-A- 2001 522 142
- JP-A- 2003 289 044
- JP-A- 2003 289 045
- US-A1- 2003 029 571

## Description

### TECHNICAL FIELD

The present invention relates to a susceptor used for a vapor-phase growth reactor for growing an epitaxial layer on a surface of a silicon wafer (hereinafter, simply referred to as a wafer) used for a semiconductor device and, particularly, relates to a susceptor for a vapor-phase growth reactor capable of suppressing rising of a dopant concentration of an outer circumferential portion of an epitaxial film caused by auto-doping.

### BACKGOUND ART

As a vapor-phase growth reactor for growing an epitaxial film having a high quality film property on a wafer surface, a single wafer vapor-phase growth reactor is often used.

This single wafer vapor-phase growth reactor grows an epitaxial film on a wafer surface by placing a wafer on a disk-shaped susceptor formed by coating silicon carbide SiC on graphite as a mother material in a channel-shaped chamber made by quartz and bringing the wafer react with various material gases passing through the chamber while heating the wafer by a heater arranged on an outer surface of the chamber.

On a surface of the susceptor for receiving the wafer, a recessed portion (depression) called a wafer pocket is formed, which is a little larger than the wafer and has a depth of 1 mm or so. By putting the wafer on the wafer pocket and holding the susceptor in a material gas flow at a predetermined temperature, growth of a silicon epitaxial layer is brought on the wafer surface.

As the material gas of vapor-phase growth reaction, a monosilane gas or a hydrogen-diluted chlorosilane based gas added with a dopant material gas of diborane (P type), phosphine or arsine (N type) is used. On the wafer surface, in addition to silicon epitaxy formed by thermal CVD reaction, H₂ is generated in the case of a monosilane gas and HCl is generated in the case of a chlorosilane based gas as a by-product. Therefore, while silicon epitaxy proceeds on the wafer front surface, a Si-H based atmosphere or a Si-H-Cl based atmosphere is formed on the back surface of the wafer mainly due to flowing of the gas by diffusion and deposition/etching reaction arises in a micro aspect.

For example, when performing epitaxial growth of a lower concentration than a dopant concentration of the wafer, such as a case of performing epitaxial growth of a P type (having resistivity of 1 Ω·cm) film on a wafer of a dopant concentration of P⁺⁺ type (having resistivity of 5 mΩ·cm), a phenomenon is observed that the dopant concentration rises at a wafer outer circumferential portion in the epitaxial layer.

This kind of phenomena are called auto-doping and the cause is considered that a dopant seeds in the wafer are discharged in a Si-H based atmosphere or a Si-H-Cl based atmosphere on the back surface of the wafer and the dopant seeds flow to the wafer front surface due to gas dispersion toward the front surface so as to partially raise a dopant concentration in the vapor phase. As a result, there arises a region where a dopant concentration becomes uncontrollable in the epitaxial layer, which leads to a decline of a nondefective rate.

To prevent variation of dopant densities of an epitaxial layer by auto-doping as above, the present inventors have previously proposed a susceptor having through hole portions formed at an outermost circumferential portion of the wafer pocket (refer to the patent article 1).

However, when forming through holes on a wafer pocket of a susceptor, radiant heat from a heater, such as a halogen lamp, provided below the susceptor passes through the through hole portions to irradiate a back surface of a wafer and there arises a temperature difference between a part facing to the through hole portions of the wafer and other part. Consequently, there has been a problem that unevenness of growth arises on the epitaxial layer and a back surface of the wafer.
Patent Article 1: The Japanese Unexamined Patent Publication No. 10-223545

US 2003/00295711 discloses a wafer holder where a uniform gap is provided between the wafer and a base plate.

WO 03/060967 discloses a susceptor for epitaxial growth in which through-holes are formed in an outer peripheral region of the susceptor which are inclined by 45° with respect to the thickness direction of the bottom wall.

### DISCLOSURE OF THE INVENTION

An object of the present invention is to provide a susceptor for a vapor-phase growth reactor capable of providing a constant temperature to a back surface of a water.
(1) To attain the above object, according to the present invention, there is provided a susceptor for a vapor-phase growth reactor as mentioned in claim 1 wherein a wafer pocket for accepting a semiconductor wafer at the time of vapor-phase growth is formed, wherein a fluid passage having a shape by which radiant heat from a heat source does not directly irradiate a back surface of the semiconductor wafer at the time of vapor-phase growth is formed between a front surface and a back surface or a side surface of the wafer pocket.

In the present invention, since a fluid passage is formed between the front surface and back surface or side surface of the wafer pocket, dopant seeds released from the wafer back surface are discharged from the fluid passage without flowing to the front surface of the wafer. As a result, a dopant concentration and resistivity of the epitaxial layer can be unified without forming an oxidized film for preventing auto-doping.

Also, the fluid passage according to the present invention has a shape, by which radiant heat from a heat source does not directly irradiate the wafer back surface at the time of vapor-phase growth, so that temperature unevenness on the wafer surface is suppressed and growth unevenness on the epitaxial layer and wafer back surface can be prevented.
(2) As a shape of the fluid passage according to the present invention, that is a shape, by which radiant heat from a heat source does not directly irradiate the wafer back surface at the time of vapor-phase growth, for example, when the wafer pocket is configured to include at least a first pocket portion for loading an outer circumferential portion of the wafer and a second pocket portion having a smaller diameter than that of the first pocket portion and formed to be lower than the first pocket portion, the fluid passage is configured to have one end opening on a vertical wall of the second pocket portion and the other end opening on the back surface of the susceptor.

When configuring the wafer pocket by a multi-shelf pocket structure, a vertical wall is naturally formed on the pocket portion and the vertical wall becomes substantially perpendicular to the wafer back surface, so that irradiation of radiant heat from the heat source directly to the wafer back surface is prevented. Note that the other end of the fluid passage may open on the back surface of the susceptor or on the side surface of the susceptor.

Note that the first pocket portion according to the present invention comprises a shelf portion for loading an outer circumferential portion of the wafer and a vertical wall continuing from the shelf portion to the outside. Also, the second pocket portion according to the present invention has a smaller diameter than that of the first pocket portion, formed to be lower than the susceptor, and comprises a vertical wall continuing to the shelf portion of the first pocket portion and a horizontal surface (the horizontal surface itself does not have to be continuously horizontal) continuing to the vertical wall. Also, the second pocket portion according to the present invention is an N-th pocket portion other than the first pocket portion, that is, concepts of a third pocket portion and forth pocket portion... are included in addition to the second pocket portion coming physically second. Namely, a plurality of pocket portions having a smaller diameter than that of the first pocket portion and formed to be lower than the susceptor are all included.

Also, the susceptor according to the present invention is configured to include at least a first structure having a first pocket portion for loading an outer circumferential portion of a wafer and a second structure provided below the first structure via a fluid passage configured by a clearance between itself and the first structure, the fluid passage may be configured to have one end opening on the second vertical wall surface on a lower side of the first pocket portion and the other end opening on the back surface or side surface of the susceptor.

Namely, the fluid passage according to the present invention is not limited to the embodiment of providing holes on the susceptor structure, and the susceptor itself may be configured by combining a plurality of structures, forming a clearance by surfaces of two structures put together and using the same as a fluid passage. When applying such configuration as above, to prevent irradiation of radiant heat from the heat source directly to the wafer back surface, one end of the clearance as a fluid passage formed between the first structure and second structure opens on the vertical wall positioned below the first pocket portion. As a result, the vertical wall becomes substantially perpendicular to the wafer back surface, so that irradiation of radiant heat from the heat source directly to the wafer back surface is prevented. Note that the other end of the fluid passage may open on the back surface of the susceptor or on the side surface of the susceptor.

### BRIEF DESCRIPTION OF DRAWINGS

FIG. 1 is a schematic sectional view showing an embodiment of a vapor-phase growth reactor, wherein a susceptor according to the present invention is applied.
FIG. 2 is a half plan view and half sectional view showing an embodiment of a susceptor according to the present invention.
FIG. 3 is a half sectional view showing another embodiment of a susceptor according to the present invention.
FIG. 4 is a half plan view and half sectional view showing still another embodiment of a susceptor according to the present invention.
FIG. 5 is a half sectional view showing still another embodiment of a susceptor according to the present invention.
FIG. 6 is a graph showing a resistivity distribution of examples and comparative examples of the present invention.

### BEST MODE FOR CARRYING OUT THE INVENTION

Below, embodiments of the present invention will be explained based on the drawings.

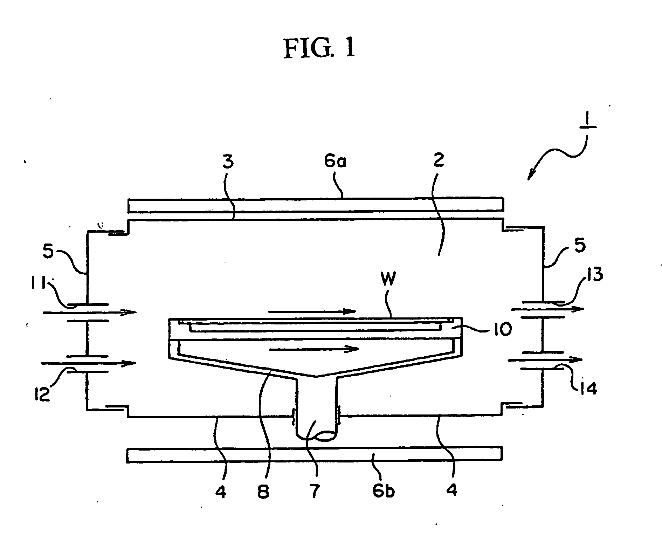

FIG. 1 is a schematic sectional view showing a single wafer vapor-phase growth reactor 1, wherein an epitaxial film forming chamber 2 formed by attaching an upper dome 3 and a lower dome 4 to a dome mount 5 is provided. The upper dome 3 and the lower dome 4 are formed by a transparent material, such as quartz, and halogen lamps 6a and 6b as heat sources are arranged above and below the device 1 to heat a susceptor 10 and a wafer W.

The susceptor 10 is supported at its outer circumferential portion of a lower surface thereof by fitting with a support arm 8 connected to a rotation axis 7 and rotated by driving the rotation axis 7. A material of the susceptor 10 is not particularly limited and, for example, a carbon base material coated with a SiC film thereon is preferably used. A shape thereof will be explained later on. Note that a method of conveying the wafer W into the susceptor 10 and conveying the wafer W out from the susceptor 10 is not particularly limited, and either of a type of reloading the wafer by moving a conveyor jig up and down by using a Bernoulli chuck and a type of supporting a wafer lower surface by pins and reloading by moving the pins up and down may be applied.

A side surface of the dome mount 5 is provided with a first gas inlet 11 and a second gas inlet 12, and a side surface facing thereto of the dome mount 5 is provided with a first gas outlet 13 and a second gas outlet 14. A reaction gas, such as SiHCl₃, obtained by diluting a Si source by a hydrogen gas and mixing the result with a minute quantity of dopant is supplied from the first gas inlet 11 to the forming chamber 2, and the supplied reaction gas passes through a surface of the wafer W to grow an epitaxial film and, then, discharged from the first gas outlet 13 to the outside of the device 1.

Note that a carrier gas, such as a hydrogen gas, is supplied from the second gas inlet 12 toward the lower surface side of the susceptor 10 and discharged from the second gas outlet 14 provided on the downstream side of the carrier gas to the outside of the device 1. As a result, dopant released from the back surface of the wafer can be discharged to the outside of the device 1 more efficiently. Note that, in the present invention, supply of a carrier gas, such as a hydrogen gas, from the second gas inlet 12 into the forming chamber 2 is not essential, so that the second gas inlet 12 and the second gas outlet 14 may be omitted if necessary. Also, when providing the second gas inlet 12 to supply a hydrogen gas or other carrier gas into the forming chamber 2, the first gas outlet 13 for discharging a reaction gas, etc. for epitaxial growth may be also used as the second gas outlet 14 without providing the second gas outlet 14.

Next, the configuration of the susceptor 10 according to the present embodiment will be explained.

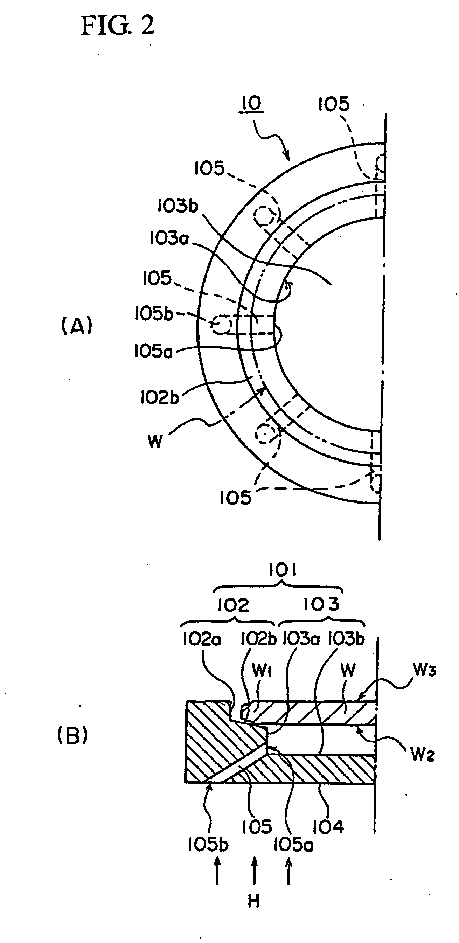

As shown in FIG. 2(A)(B), on an upper surface of the susceptor 10 in this example, a wafer pocket 101 made by a recessed portion having a little larger diameter than an outer diameter of the wafer W is formed. The wafer pocket 101 is composed of a first pocket portion 102 for supporting the wafer W by point contact, line contact or plane contact only with an outer circumferential portion W1 of the wafer W and a second pocket portion 103 having a smaller diameter than that of the first pocket portion 102 and formed on the lower side of the susceptor 10; and the wafer W is loaded so as to form a space between the back surface of the wafer and the bottom surface 103b of the second pocket portion 103 at the center of the first pocket portion 102. Note that the first pocket portion 102 is configured by a first vertical wall 102a corresponding to a vertical wall of the recessed portion and a shelf portion 102b for supporting by contacting with the outer circumferential portion 1 of the wafer W, and the second pocket portion 103 is configured by a second vertical wall 103a corresponding to a vertical wall of the recessed portion and a bottom surface 103b corresponding to a horizontal surface of the recessed portion.

As a result, flowing of a carrier gas to the back surface side of the wafer is promoted and an effect of discharging dopant released from the back surface of the wafer is enhanced. Note that the shelf portion 102b of the first pocket portion may be formed to be a tapered shape having a slope dropping from the outer circumferential side to the inner circumferential side as illustrated so as to support the outer circumferential portion W1 of the wafer W by line contact. Alternately, concave and convex portions may be provided on a surface of the shelf portion 102b to support the outer circumferential portion W 1 of the wafer W by point contact.

Particularly, as shown in the sectional view in FIG. 2(B), the susceptor 10 of the present embodiment is provided with a fluid passage 105, wherein one end 105a opens on a second vertical wall 103a of the second pocket portion and the other end 105b opens on the back surface 104 of the susceptor 10. The fluid passage 105 is composed of a plurality of holes formed in the circumferential direction of the susceptor 10 as shown in the plan view in FIG. 2(A). The fluid passage 105 in this example is for discharging dopant diffused from the wafer back surface W2 by heating at the time of vapor-phase growing or dopant released from the wafer back surface W2 by vapor-phase etching from the lower surface of the susceptor 10 to prevent flowing of the dopant to the wafer front surface W3 side.

Additionally, the fluid passage 105 in this example has a shape, by which radiant heat H from the halogen lamp 6b provided below the device 1 does not directly irradiate the wafer back surface W2 via the fluid passage 105. As a result, radiant heat H emitted from the halogen lamp 6b is prevented from directly irradiating the wafer back surface W2 through the fluid passage 105, so that it is possible to prevent arising of a temperature difference between a temperature of a part facing to the part provided with the fluid passage 105 on the wafer W and a temperature of a part facing to a not provided part, consequently, generation of growth unevenness on the epitaxial layer and the wafer back surface can be prevented.

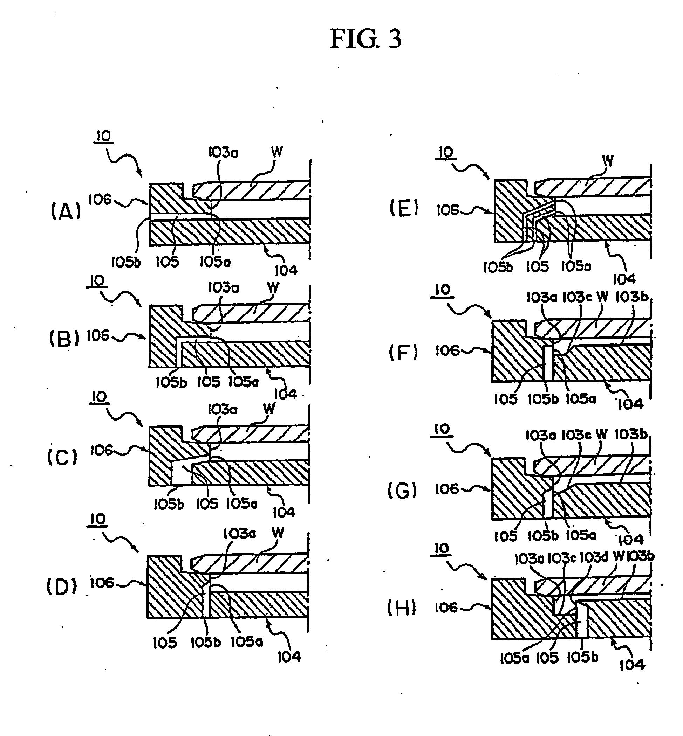

A shape of the fluid passage 105 according to the present invention is not specifically limited as far as it is shaped, so that radiant heat H from the halogen lamp 6b provided below the device 1 does not directly irradiate the wafer back surface W2 via the fluid passage 105. Typical modification examples are shown in FIG. 3(A) to (H). The fluid passage 105 shown in FIG. 3(A) is configured to have one end 105a opening on the second vertical wall 103a of the second pocket portion and the other end 105b opening on the side surface 106 of the susceptor 10. According to the fluid passage 105 of this example, it is possible to prevent radiant heat from the halogen lamp 6b from directly irradiating the wafer back surface W2 more comparing with the example shown in FIG. 2.

Also, the fluid passage 105 shown in FIG 3(B) is the same as the example shown in FIG. 2 in a point that it is configured to have one end 105a opening on the second vertical wall 103a of the second pocket portion and the other end 105b opening from the second vertical wall 103a of the second pocket portion to the outside, which is the back surface 104 of the susceptor 10; however, a shape of the fluid passage 105 is not a linear shape and is formed to be a curved nonlinear shape. Accordingly, radiant heat from the halogen lamp 6b enters to the middle of the fluid passage 105 but the radiant heat is blocked at a curved portion of the fluid passage 105 and does not go further to the wafer back surface W2 direction.

The fluid passage 105 shown in FIG 3(C) is the same as the example shown in FIG. 3(B) in points that it is configured to have one end 105a opening on the second vertical wall 103a of the second pocket portion and the other end 105b opening to the outside from the second vertical wall 103a of the second pocket portion, which is a back surface 104 of the susceptor 104, and also a curved portion is provided in the middle of the fluid passage 105; however, an inner diameter of the fluid passage 105 on the other end 105b side is formed to be larger than an inner diameter of the fluid passage 105 on the end **105a** side.

The fluid passage 105 of the example shown in FIG. 3(D) is the same as the examples shown in FIG. 3(B) and (C) in a point that it has one end 105a opening on the second vertical wall 103a of the second pocket portion and the other end 105b opening to the outside from the second vertical wall 103a of the second pocket portion, which is a back surface 104 of the susceptor 104; but is different in a point that the fluid passage 105 is formed to be a linear shape.

The example shown in FIG. 3(E) is formed that the fluid passages 105 are arranged one above the other, so that openings of one ends 105a are arranged one above the other on the second vertical wall 103a.

The fluid passage 105 of an example shown in FIG. 3(F) is the same as the examples shown in FIG. 3(B) and (C) in a point that it has one end 105a opening on the second vertical wall 103a of the second pocket portion and the other end 105b opening to the outside from the second vertical wall 103a of the second pocket portion, which is a back surface 104 of the susceptor 104 and is the same as the example shown in FIG. 3(D) in a point that the fluid passage 105 is formed to be a linear shape; however, it is different in a point that a recessed portion 103c is formed on an outer circumference of the bottom surface 103b of the second pocket portion 103 and a point that the bottom surface 103b of the second pocket portion 103 is formed to be shallower comparing with that in the examples in FIG. 3(A) to (E). Also, one end 105a of the fluid passage 105 opens on the second vertical wall 103a corresponding to the recessed portion 103c. Note that the recessed portion 103c of the second pocket portion 103 may be formed continuously over the outer circumference or discontinuously. The fluid passage 105 of this example is also shaped, so that radiant heat H from the halogen lamp 6b provided below the device 1 does not directly irradiate the wafer back surface W2 via the fluid passage 105.

When the bottom surface 103b of the second pocket portion 103 is formed shallow as explained above, radiant heat from the back surface of the susceptor 10 easily transfer to the inner circumferential portion of the wafer W and a temperature difference from a temperature of the outer circumferential portion of the wafer becomes small. As a result, the slip dislocation of the wafer deemed to be caused by thermal stress by the temperature difference is prevented.

The fluid passage 105 of an example shown in FIG. 3(G) is the same as the example shown in FIG. 3(F) in a point that the recessed portion 103c is formed on an outer circumference of the second pocket portion 103, but the recessed portion 103c is configured only by a slope dropping toward the outer side. One end 105a of the fluid passage 105 opens on the second vertical wall 103a corresponding to the recessed portion 103c formed by the slope. Note that the recessed portion 103c of the second pocket portion 103 may be formed continuously over all outer circumference or discontinuously. The fluid passage 105 of this example is also shaped, so that radiant heat H from the halogen lamp 6b provided below the device 1 does not directly irradiate the wafer back surface W2 via the fluid passage 105.

The example shown in FIG. 3(H) is the same as the example shown in FIG. 3(F) in a point that the recessed portion 103c is formed on an outer circumference of the second pocket portion 103, but is different in a point that a third vertical wall 103d is furthermore provided in addition to the second vertical wall 103a of the second pocket portion 103 and faces to the same. Also, the bottom surface 103b of the second pocket portion 103 is formed to be shallow in the same way as in the examples of FIG. 3(F) and (G). One end 105a of the fluid passage 105 opens on the third vertical wall 103d of the recessed portion 103c, the other end 105b opens to the inside from the second vertical wall 103a of the second pocket portion, which is a back surface 104 of the susceptor 10, and the fluid passage 105 is formed to be a linear shape. Note that the recessed portion 103c of the second pocket 103 may be formed continuously over all outer circumference or discontinuously. The fluid passage 105 of this example is also shaped, so that radiant heat H from the halogen lamp 6b provided below the device 1 does not directly irradiate the wafer back surface W2 via the fluid passage 105.

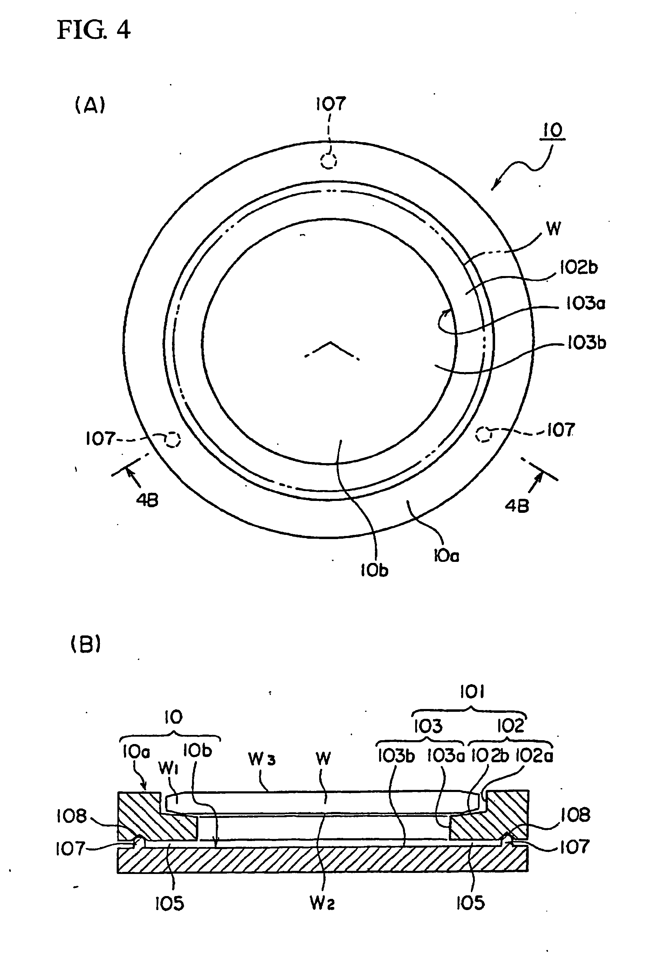

The susceptor 10 according to the present invention may be furthermore modified. FIG. 4 is a half plan view and half sectional view showing still another embodiment of the susceptor according to the present invention. In this example, the susceptor 10 itself is configured by combining two structures 10a and 10b, and a clearance is formed between the surfaces of putting the two structures 10a and 10b together and used as a fluid passage 105.

Namely, as shown in FIG. 4(B), the susceptor 10 of this example is configured by putting the first structure 10a on the second structure 10b, and a fluid passage 105 is formed as a clearance between the surfaces of putting the first and second structures 10a and 10b together.

To put the first structure 10a on the second structure 10b by leaving a clearance, an outer circumferential portion of an upper surface of the second structure 10b has three protrusions 107 formed at positions at regular intervals of, for example, 120 degrees as shown by a dotted line in FIG. 4(A). Also, on an outer circumferential portion on a back surface of the first structure 10a, groove portions 108 for receiving the protrusions 107 are formed at proper positions corresponding to the protrusions 107 (meaning proper positions for a positional relationship of the first structure 10a and the second structure 10b). If it is only for supporting the first structure 10a by the second structure 10b, the object is attained by providing protrusions 107 at least at three positions without providing groove portions 108, however, by providing the groove portions 108 at proper positions corresponding to the protrusions 107 as in this example, a function of aligning at the time of matching the first structure 10a with the second structure 10b is also given. The protrusions 107 correspond to the support means according to the present invention, and the protrusions 10 and the groove portions 108 correspond to the aligning means according to the present invention.

When configuring the susceptor 10 by putting the two structures 10a and 10b together as explained above, the whole circumference formed by the surfaces of the structures 10a and 10b put together becomes a fluid passage 105, so that dopant released from the wafer back surface W2 at the time of vapor-phase growth can be furthermore effectively discharged from the fluid passage 105 formed by the whole circumference without letting it flow to the wafer front surface W3. Also, the fluid passage 105 is formed by a clearance by simply putting the first structure 10a and the second structure 10b together without forming a hole to be a fluid passage 105, it is convenient in terms of processing.

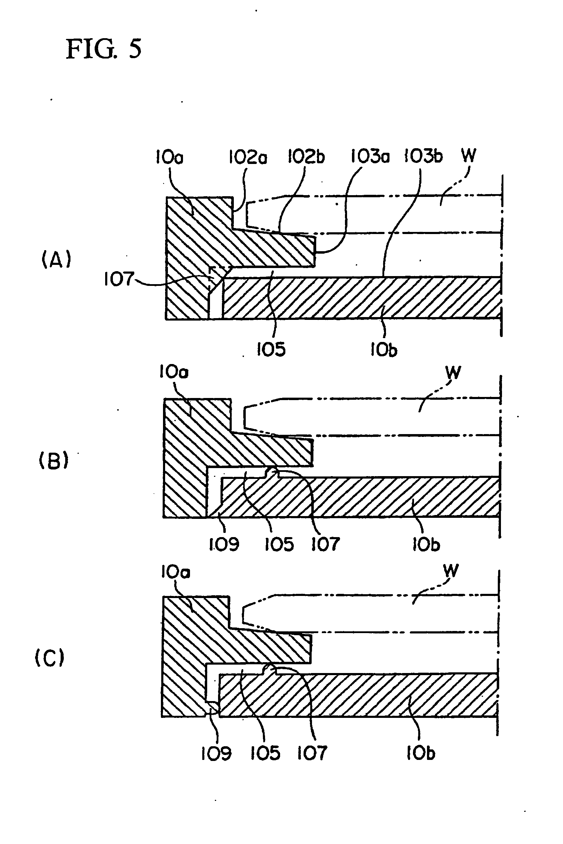

A shape of the susceptor 10 shown in FIG. 4 is not specifically limited as far as it forms a clearance to configure the fluid passage 105 on the surfaces put together at the time of putting the first structure 10a and the second structure 10b together and, furthermore, the fluid passage 105 as the clearance becomes a shape for preventing radiant heat from the halogen lamp 6b provided below the device 1 from directly irradiating the wafer back surface W2 via the fluid passage 105. Typical modification examples are shown in FIG. 5(A) to (C).

The susceptor 10 shown in FIG. 5(A) is configured that the fluid passage 105 formed by the surfaces of the first structure 10a and the second structure 10b put together becomes a curved shape as shown in FIG. 3(B), wherein protrusions 107 are provided at three positions at regular intervals on the back surface of the first structure 10a, and the first structure 10a is supported by the second structure 10b as a result that the protrusions 107 contact with edges on the surface of the second structure 10b.

Also, the susceptor 10 shown in FIG. 5(B) is also configured that a shape of the fluid passage 105 becomes a curved shape in the same way as the fluid passage 105 shown in FIG. 5(A), wherein in addition to forming the protrusions 107 as a support means on the surface of the second structure 10b, protrusions 109 as an aligning means are formed on a side surface of the second structure 10b and a proper position of the first structure 10a and the second structure 10b is determined as a result that the protrusions 109 contact with the side wall on the back surface of the first structure 10a.

Furthermore, the susceptor 10 shown in FIG. 5(C) is also configured that a shape of the fluid passage 105 becomes a curved shape in the same way as the fluid passage 105 shown in FIG. 5(A) and the protrusions 107 as a support means are formed on the surface of the second structure 10b; wherein protrusions 109 as an aligning means are formed on the side wall on the back surface of the first structure 10a and a proper position of the first structure 10a and the second structure 10b is determined as a result that the protrusions 109 contact with the side surface of the second structure 10b.

In any of the susceptors 10 shown in FIG. 5(A) to (C), the whole circumference formed by the surfaces of the structures 10a and 10b put together becomes the fluid passage 105 in the same way as the susceptor 10 shown in FIG. 4, so that dopant released from the wafer back surface W2 at the time of vapor-phase growth can be furthermore effectively discharged from the fluid passage 105 formed by the whole circumference without letting it flow to the wafer front surface W3. Also, the fluid passage 105 is formed by a clearance by simply putting the first structure 10a and the second structure 10b together without forming a hole to be a fluid passage 105, it is convenient in terms of processing.

Furthermore, the fluid passage 105 has a shape that radiant heat emitted from the halogen lamp 6b does not directly irradiate the wafer back surface W2 through the fluid passage 105, so that it is possible to prevent arising of a temperature difference between a temperature of a part facing to the part provided with the fluid passage 105 on the wafer W and a temperature of a part facing to a not provided part, consequently, generation of growth unevenness on the epitaxial layer and the wafer back surface can be prevented.

Note that the embodiments explained above are described to facilitate understanding of the present invention and is not to limit the present invention. Accordingly, respective elements disclosed in the above embodiments include all design modifications and equivalents belonging to the technical scope of the present invention.

For example, the susceptor of the present invention was explained by taking the single wafer vapor-phase growth reactor 1 as an example in the above embodiment, however, the susceptor of the present invention is not limited to that and may be naturally applied to a conventionally used batch vapor-phase growth reactor for performing processing on a plurality of wafers at a time.

### EXAMPLES

Below, examples of the present invention will be explained by comparing with comparative examples to clarify the effects of the present invention.

As a unified condition of examples and comparative examples, a P⁺ type silicon monocrystal wafer having a diameter of 200 mm, a main surface in a surface direction of (100) and resistivity of 15 mΩ·cm was used to grow on the wafer surface a P type epitaxial film having a thickness of about 6µm and resistivity of 10 Ω·cm at an epitaxial growth temperature of 1125°C by performing hydrogen baking at 1150°C for 20 seconds and supplying a mixed reaction gas obtained by diluting SiHCl₃ as a silicon source and B₂H₆ as a boron-dopant source by a hydrogen gas into the vapor-phase growth reactor.

In the examples, the single wafer vapor-phase growth reactor shown in FIG. 1 was used and a susceptor having a shape shown in FIG. 3(C) was used. Specifically, holes composing a fluid passage (a large hole width was 2 mm, a small hole diameter was 1 mmφ, and a slit shape having a width of 2 mm) were formed allover the second vertical wall at 4mm pitch intervals (a distance between centers of the slits).

In comparative examples, in the same way as in the examples, the single wafer vapor-phase growth reactor shown in FIG. 1 was used, but a fluid passage was not formed in the susceptor.

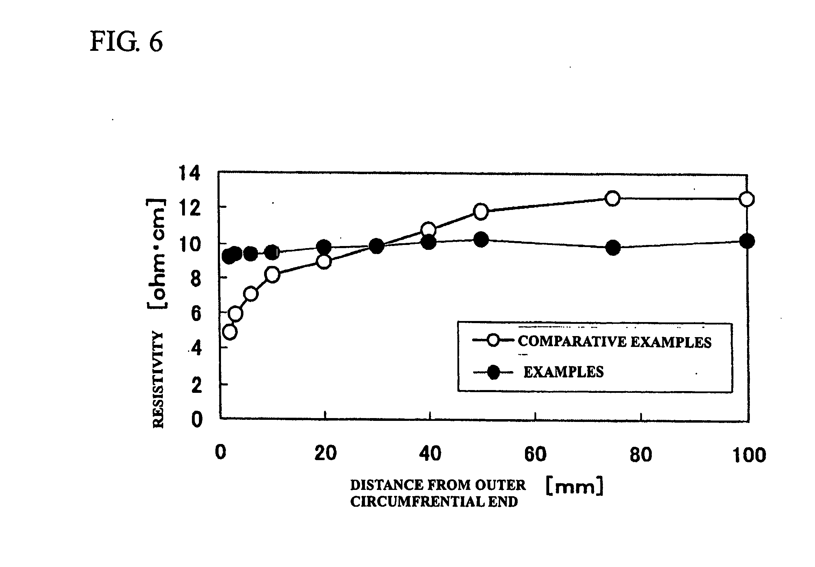

In respective epitaxial silicon wafers obtained as the examples and comparative examples, a dopant concentration distribution in the radial direction in the epitaxial film was measured on a region from an outer circumferential end to 100 mm by using an SCP device (Surface Charge Profiler). Based on the measurement results, a resistivity distribution in the radial direction in the epitaxial film was obtained. The results are shown in FIG. 6.

As is obvious from FIG. 6, it was confirmed that a P type epitaxial film having a resistivity of 10 Ω·cm was obtained uniformly on the surface as desired. On the other hand, in the comparative examples, a resistivity distribution was confirmed to be widely declined on the outer circumferential portion.

## Claims

1. A susceptor (10) for vapor-phase growth having a wafer pocket for a semiconductor wafer, comprising:
said wafer pocket (101) having at least a first pocket portion (102) for loading an outer circumferential portion of said semiconductor wafer and a second pocket portion (103) having a smaller diameter than that of the first pocket portion and formed to be lower than the first pocket portion;
a fluid passage (105) having one end opening on a vertical wall surface (103a) of said second pocket portion and another end opening on a back surface of said susceptor (10) is formed; and
a recessed portion (103c) formed on an outer circumference of a bottom surface (103b) of the second pocket portion;
wherein the bottom surface (103b) is formed to be shallow so that the bottom surface is higher than the one end opening of said fluid passage.

2. The susceptor for vapor-phase growth as set forth in claim 1, wherein an opening on the back surface side of said susceptor in said fluid passage is formed on an outer side than a vertical wall surface of said second pocket portion.

3. The susceptor for vapor-phase growth as set forth in claim 1, wherein said fluid passage (105) is formed to be a linear shape.

4. The susceptor for vapor-phase growth as set forth in claim 1, wherein a plurality of said fluid passages (105) is formed and ends of the fluid passages open substantially evenly along a circumferential direction of the vertical wall surface (103a) of said second pocket portion.

## Patentansprüche

1. Suszeptor für Dampfphasenepitaxie mit einer Wafertasche für einen Halbleiter-Wafer, umfassend:
die Wafertasche (101), welche mindestens einen ersten Taschenabschnitt (102) zum Laden eines Außenumfangabschnitts des Halbleiter-Wafers und einen zweiten Taschenabschnitt (103), welcher einen kleineren Durchmesser als denjenigen des ersten Taschenabschnitts aufweist und ausgebildet ist, um tiefer als der erste Taschenabschnitt zu sein, aufweist;
einen Fluiddurchgang (105), welcher eine Endöffnung auf einer vertikalen Wandfläche (103a) des zweiten Taschenabschnitts aufweist, und wobei eine andere Endöffnung auf einer rückseitigen Fläche des Suszeptors (10) ausgebildet ist; und einen vertieften Abschnitt (103c), welcher auf einem Außenumfang einer Bodenfläche (103b) des zweiten Taschenabschnitts ausgebildet ist;
wobei die Bodenfläche (103b) ausgebildet ist, um flach zu sein, so dass die Bodenfläche höher als die eine Endöffnung des Fluiddurchgangs ist.

2. Suszeptor für Dampfphasenepitaxie nach Anspruch 1, wobei eine Öffnung auf der Seite der rückseitigen Fläche des Rezeptors in dem Fluiddurchgang auf einer Außenseite als eine vertikale Wandfläche des zweiten Taschenabschnitts ausgebildet ist.

3. Suszeptor für Dampfphasenepitaxie nach Anspruch 1, wobei der Fluiddurchgang (105) ausgebildet ist, um eine gradlinige Form aufzuweisen.

4. Suszeptor für Dampfphasenepitaxie nach Anspruch 1, wobei eine Mehrzahl der Fluiddurchgänge (105) ausgebildet ist und sich Enden der Fluiddurchgänge im Wesentlichen gleichmäßig entlang einer Umfangsrichtung der vertikalen Wandfläche (103a) des zweiten Taschenabschnitts öffnen.

## Revendications

1. Suscepteur (10) pour une croissance en phase vapeur comportant un logement de tranche pour une tranche semi-conductrice, dans lequel :
ledit logement de tranche (101) comporte au moins une première partie de logement (102) pour charger une partie circonférentielle externe de ladite tranche semi-conductrice et une deuxième partie de logement (103) ayant un diamètre plus petit que celui de la première partie de logement et formée de manière à être plus basse que la première partie de logement ;
un passage de fluide (105) comportant une ouverture d'extrémité sur une surface de paroi verticale (103a) de ladite deuxième partie de logement et une autre ouverture d'extrémité sur une surface arrière dudit suscepteur (10) est formé ; et
une partie évidée (103c) est formée sur une circonférence externe d'une surface inférieure (103b) de la deuxième partie de logement ;
dans lequel la surface inférieure (103b) est formée de manière à être peu profonde de sorte que la surface inférieure soit plus haut que ladite une ouverture d'extrémité dudit passage de fluide.

2. Suscepteur pour une croissance en phase vapeur selon la revendication 1, dans lequel une ouverture du côté de surface arrière dudit suscepteur dans ledit passage de fluide est formée sur un côté plus à l'extérieur qu'une surface de paroi verticale de ladite deuxième partie de logement.

3. Suscepteur pour une croissance en phase vapeur selon la revendication 1, dans lequel ledit passage de fluide (105) est formé de manière à avoir une forme linéaire.

4. Suscepteur pour une croissance en phase vapeur selon la revendication 1, dans lequel une pluralité desdits passages de fluide (105) sont formés et les extrémités des passages de fluide s'ouvrent sensiblement régulièrement le long d'une direction circonférentielle de la surface de paroi verticale (103a) de ladite deuxième partie de logement.
